# EUROPEAN PATENT SPECIFICATION

(11) **EP 2 761 051 B1**
(45) Date of publication and mention of the grant of the patent: **07.11.2018**
(21) Application number: 11773699.1
(22) Date of filing: 27.09.2011
(51) Int. Cl.: C23C 14/50

(54) **CARRIER FOR THIN GLASS SUBSTRATES AND USE THEREOF**
TRÄGER FÜR DÜNNE GLASSUBSTRATE UND VERWENDUNG DAVON
SUPPORT POUR SUBSTRATS DE VERRE MINCES ET UTILISATION DE CELUI-CI

(43) Date of publication of application: 06.08.2014
(73) Proprietor: Applied Materials, Inc., Santa Clara, CA 95054 (US)
(72) Inventor: BRÜNING, Andre, 63811 Stockstadt (DE); HEIMEL, Oliver, 34590 Wabern (DE); HINTERSCHUSTER, Reiner, 63546 Hammersbach (DE); WOLF, Hans Georg, 63526 Erlensee (DE)
(74) Representative: Zimmermann & Partner Patentanwälte mbB
(86) International application number: PCT/EP2011/066780
(87) International publication number: WO 2013/044941

(56) References cited:
- DE-A1-102004 027 898
- JP-A- 2000 336 476
- KR-A- 20090 110 863
- US-A1- 2011 020 978

## Description

### TECHNICAL FIELD OF THE INVENTION

Embodiments of the present invention relate to carriers for substrate processing, e.g., for layer deposition, and method utilizing such carriers. Embodiments of the present invention particularly relate to carriers and methods of substrate, which are vertically oriented during processing. Specifically they relate to carriers for supporting a large area substrate in a substrate processing machine, apparatuses for processing a large area substrate, and methods of processing a large area substrate

### BACKGROUND OF THE INVENTION

Several methods are known for depositing a material on a substrate. For instance, substrates may be coated by a physical vapor deposition (PVD) process, a chemical vapor deposition (CVD) process, a plasma enhanced chemical vapor deposition (PECVD) process etc. Typically, the process is performed in a process apparatus or process chamber, where the substrate to be coated is located. A deposition material is provided in the apparatus. A plurality of materials, but also oxides, nitrides or carbides thereof, may be used for deposition on a substrate. Further, other processing steps like etching, structuring, annealing, or the like can be conducted in processing chambers.

Coated materials may be used in several applications and in several technical fields. For instance, an application lies in the field of microelectronics, such as generating semiconductor devices. Also, substrates for displays are often coated by a PVD process. Further applications include insulating panels, organic light emitting diode (OLED) panels, substrates with TFT, color filters or the like.

Particularly for areas such as display production, manufacturing of thin-film solar cells and similar applications, large area glass substrates are used to be process. In the past, there has been a continuous increase in substrate sizes which is still to be continued. The increase glass substrate make handling, supporting and processing of the substrates increasingly challenging without sacrificing the throughput by glass breakage.

Typically, glass substrates can be supported on carriers during processing thereof. A carrier drives the glass or the substrate through the processing machine. The carriers typically form a frame or a plate, which supports a surface of the substrate along the periphery thereof or, in the latter case, supports the surface as such. Particularly, a frame shaped carrier can also be used to mask a glass substrate, wherein the aperture in the carrier, which is surrounded by the frame, provides an aperture for coating material to be deposited on the exposed substrate portion or an aperture for other processing steps acting on the substrate portion, which is exposed by the aperture.

Document JP 2000-336476 A discloses a glass substrate carrier in a deposition chamber.

The tendency to larger and also thinner glasses can result in bulging of the glass substrates, which can in turn cause problems due to increasing likelihood of glass breakage. Accordingly, there is a desire to reduce or avoid bulging and to enables a carrier to transport bigger and thinner substrates without glass breakage.

In view of the above, it is an object of the present invention to provide a mask, particularly an edge exclusion mask, a deposition apparatus having a mask, and a method of masking the edges of a substrate that overcome at least some of the problems in the art.

### SUMMARY OF THE INVENTION

In light of the above, a carrier for supporting a large area substrate according to independent claim 1, an apparatus according to dependent claim 7 and a method according to independent claim 8 are provided. Further aspects, advantages, and features of the present invention are apparent from the dependent claims, the description, and the accompanying drawings.

According to one embodiment, a carrier for supporting a large area substrate, e.g. having an area of at least 0.174 m², in a substrate processing chamber is provided. The carrier includes at least one fixation element configured to hold the substrate at the substrate's upper side and configured to carry at least 60% of the substrate's weight during processing of the substrate, and at least one support portion adapted to hold the substrate at an essentially vertical orientation during processing of the substrate.

According to another embodiment, an apparatus for processing a large area substrate is provided. The apparatus includes a vacuum chamber adapted for layer deposition therein, a transport system adapted for transportation of a carrier according to embodiments described herein, and a deposition source for depositing material forming the layer. Typically, the essentially vertical orientation is provided with respect to the processing chamber.

According to a further embodiment, a method of processing a large area substrate is provided. The method includes loading the large area substrate, e.g. having a size of 0.174 m² and above, on a carrier, transferring the carrier together with the substrate into a processing chamber, wherein the substrate is in an essentially vertical orientation, wherein the substrate is hanging at the carrier, and processing the substrate.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- FIG. 1: illustrates a carrier according to embodiments described herein, and having a fixation assembly and with a substrate provided in a substrate area of the carrier;
- FIG. 2: shows a perspective view of a portion of a carrier with an upper fixation element according to embodiments described herein;
- FIG. 3: shows another example of an upper fixation element according to embodiments described herein;
- FIGS. 4 and 5: show yet another examples upper fixation elements according to embodiments described herein;
- FIG. 6: shows a view of an apparatus for depositing a layer of material on a substrate utilizing a carrier according to embodiments described herein; and
- FIG. 7: shows a flow chart illustrating a method for depositing material on a substrate according to embodiments described herein, wherein a carrier is utilized.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

Typically, substrates such as glass substrates can be fixed to a carrier in two basically two different ways. They can be fixed with clamps (e.g. spring clips), wherein they are pressed to the carrier frame. Such springs are available in a various number of different designs. Further, the substrate can be fixed at the edges thereof, i.e. they are pressed at the lateral edges of the substrate parallel to the glass surface. Thereby, clamps embrace or envelop the substrate. Thereby, commonly the lower edge of the substrate, e.g. a large area glass substrate, is supported and majority or at least a significant portion of the gravity forces of the substrate is loaded on the lower edge of the substrate. The clamps, particularly clamps at the top of the substrate, clamps at the side of the substrate and non-embracing or non-enveloping clamps at the bottom of the substrate, thereby secure the position of the substrate while the gravity forces relating to the weight of the substrate are received at the support of the lower edge of the substrate. This can result in bulging of the glass substrate and, thus, in an increased likelihood of glass breakage.

According to embodiments described herein, a glass substrate can be supported by a support assembly, which can also include clamps, particularly claims, which are modified as compared to the commonly used clamps. However, the weight of the glass is not received at the lower edge thereof but mostly (e.g. at least 50 % or at least 60% or even at least 80%) at the upper edge thereof. Thereby, according to embodiments, which can be combined with other embodiments described herein, the glass strains the bottom edge of the substrate with its own weight. Embodiments can provide a decrease in glass breakage, particularly in light of the fact that the substrates are getting bigger in length and height, however, the thickness of the substrates decreases from about 0.7 mm, to about 0.5 mm and even down to 0.3 mm.

According to typical embodiments, which can be combined with other embodiments described herein, the glass thickness can be from 0.1 to 1.8 mm and the fixation elements can be adapted for such glass thicknesses. However, particularly beneficial the glass thickness is about 0.9 mm or below, such as 0.5 mm or 0.3 mm and the fixation elements are adapted for such glass thicknesses.

According to some embodiments, large area substrates may have a size of at least 0.174 m². Typically the size can be about 1.4 m² to about 8 m², more typically about 2 m² to about 9 m² or even up to 12 m². Typically, the rectangular substrates, for which the mask structures, apparatuses, and methods according to embodiments described herein are provided, are large area substrates as described herein. For instance, a large area substrate can be GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m × 3.05 m). Even larger generations such as GEN 11 and GEN 12 and corresponding substrate areas can similarly be implemented.

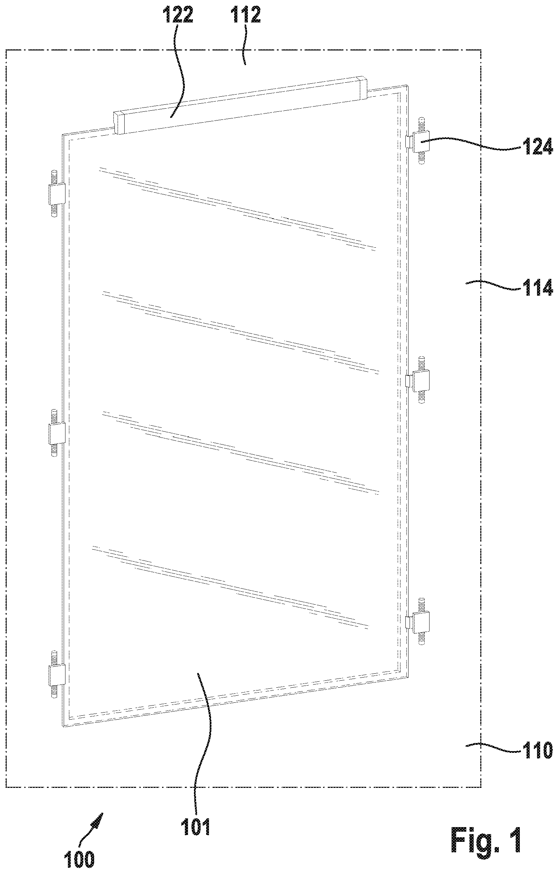

Figure 1 shows a carrier 100, such as a suspension carrier. The carrier 100 is configured for supporting a large area substrate 101. As shown in figure 1, the substrate is provided in a vertical position within the carrier, particularly when processed in a processing chamber. The carrier 100 includes the support portion 110. Typically, the support portion can include a carrier plate. According to some embodiments, which can be combined with other embodiments described herein, the carrier plate can be an aluminum plate, a titanium plate or a stainless steel plate. Yet further, the carrier plate can have a window or aperture.

Particularly for large area substrates, the support portion can have a plurality of elements such as a top plate 112 and a sidebar 114. The support portion 110 is configured for receiving the substrate 101 in the substrate area. Thereby, a surface of the support portion or carrier plate is configured for being in contact with at least the periphery of the substrate 101. The example shown in figure 1 includes an aperture of the support portion 110 which is, in Fig. 1, covered by the substrate. Accordingly, with respect to the view shown in figure 1, the substrate 101 will be processed from the backside of the paper plane.

The carrier 100 further includes a fixation assembly. The fixation assembly includes at least one fixation element 122, e.g. a top side or upper fixation element. According to embodiments described herein, the upper fixation element 122 is configured for carrying the entire weight, a majority of the weight or essentially the entire weight of the substrate 101. Accordingly, as illustrated in the example shown in figure 1, the substrate 101 is hanging. Thereby, the upper fixation element 122 is receiving the loads of the gravity forces corresponding to the weight of the substrate. Accordingly, the lower edge of the substrate 101 is not supported by a support plane on which the substrate could rest upon. Thereby, bulging of the substrate can be reduced or avoided because the substrate straightens by its own weight.

According to yet further embodiments, which can be combined with other embodiments described herein, additional fixation elements 124, for example clamps or guiding means can be provided at the side of the substrate or even at the bottom of the substrate in order to receive forces, which are essentially perpendicular to the gravity forces occurring in the vertical substrate position. The additional fixation elements at the side or bottom do not essentially contribute to the compensation of gravity forces. Rather, they are adapted to avoid free movement of the substrate in a horizontal plane.

For instance, the substrate may be made from a material selected from the group consisting of glass (for instance soda-lime glass, borosilicate glass etc.), metal, polymer, ceramic, compound materials, carbon fiber materials or any other material or combination of materials which can be coated by a deposition process. Typically, the substrate can be a glass substrate, which tends to be more critical with respect to breakage. However, as bulging might also result in other problems, other substrates can also beneficially utilize embodiments described herein.

According to some embodiments, the support portion of the carrier 100 can include a frame. For example, the frame can be made of aluminum, aluminum alloys, titanium, alloys thereof, stainless steel or the like. For comparably small large area substrates, e.g. GEN 5 or below, the support portion can be manufactured from a single piece, i.e. the frame or plate is integrally formed. However, according to some embodiments, which can be combined with other embodiments described herein, the support portion 110 can include two or more elements such as a top plate 112, the sidebar 114, corner portions, or two or more side elements and top elements. Thereby, particularly for very large area substrates, the carrier can be manufactured having several portions. These portions of the carrier are assembled to provide the frame or plate for supporting the substrate 101.

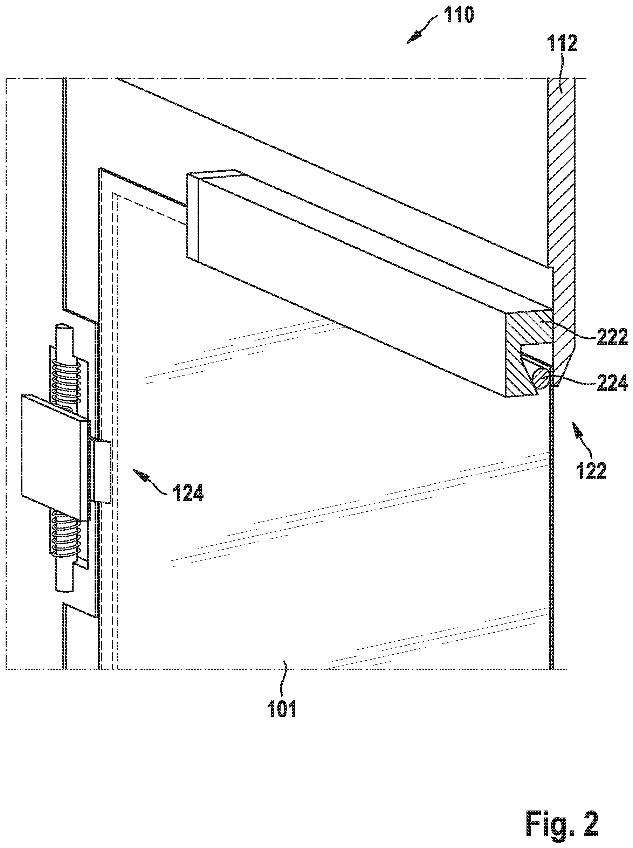

According to embodiments described herein, the substrate is hanging within the carrier, i.e. a majority of the weight or essentially all gravity forces relating to the weight of the substrate are received by upper fixation element. Figure 2 illustrates an example of the upper fixation element 122. The upper fixation element 122 can include the beveled housing portion 222 and a roller 224 included therein. The beveled housing portion for the roller increases the pressure on the substrate upon gravity forces acting on the substrate when the roller 224 is pulled downward. Thereby, the substrate can be fixed at the upper fixation element 122.

According to some embodiments, which can be combined with other embodiments described herein, the roller-and-bevel clamp including the beveled housing portion and the roller, includes a roller which pushes the substrate in dependency on its own weight against a contact face of the carriers top plate. According to typical optional implementations of embodiments, which are not limiting, the roller can be made of a heat-proofed plastic like Peek, Meldin, rubber-like materials (e.g. Kalrez) or materials like aluminum or quartz glass.

The roller pushes the substrate in dependency on its own weight against a contact face of the carrier's top plate. According to some embodiments, which can be combined with other embodiments described herein, the roller can be made of a heat-resistance plastic like Peek, Meldin, rubber-like materials (e.g. Kalrez) or materials like aluminum or quartz glass.

According to some embodiments, which can be combined with other embodiments described herein, the upper fixation element 122 can extend along a length being at least 50% of the length of the upper side of the substrate. Thereby, it can be ensured that the receipt of the gravity forces is conducted over a majority of the top side of the substrate 101. This avoids punctual forces on the substrate, which might result in strain and stress and, thus, glass breakage.

As shown in figure 2, the side fixation element 124 is provided at a side portion of the frame forming the support portion 110. However, the side fixation element 124 essentially prevents that the substrate 101 moves away from the contact surface of the support portion 110 or moves horizontally along the contact surface with respect to the vertical orientation of the carrier or substrate, respectively.

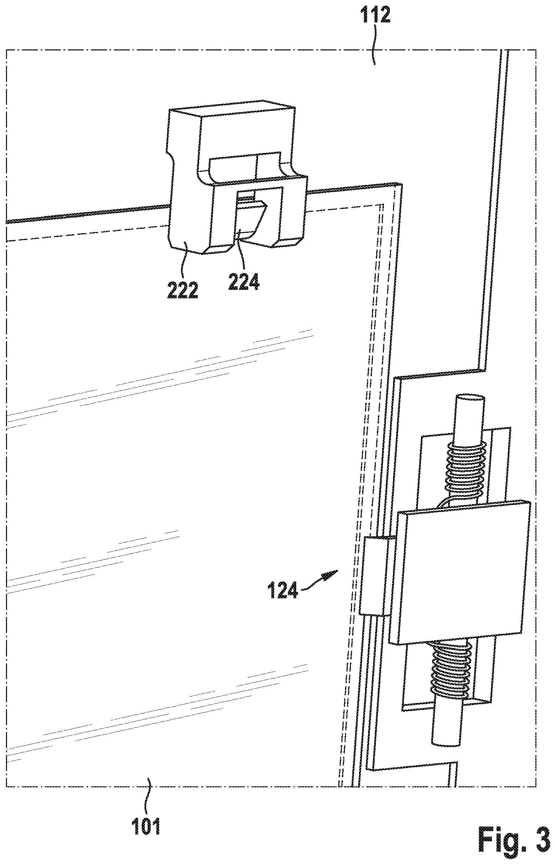

Figure 3 illustrates yet further embodiments of the carrier and of upper fixation elements 122. As shown in figure 3, a housing portion 222 and a roller 224 have a shorter length as compared to the embodiment shown in figure 2. However, two, three, four, five, six or more of the shorter upper fixation elements, i.e. shorter rollers 224, can be provided along the top side of the substrate 101. Typically, the plurality of upper fixation elements can be distributed over a length being at least 50% of the length top side of the substrate or the substrate receiving area, respectively. Thereby, the forces received by the upper fixation element, which opposes essentially all of the gravity forces of the substrate, can be distributed along the top side of the substrate. Accordingly, as described above different implementations can include two or more rollers allocated over the length of the substrate or at least one roller with a larger roll width.

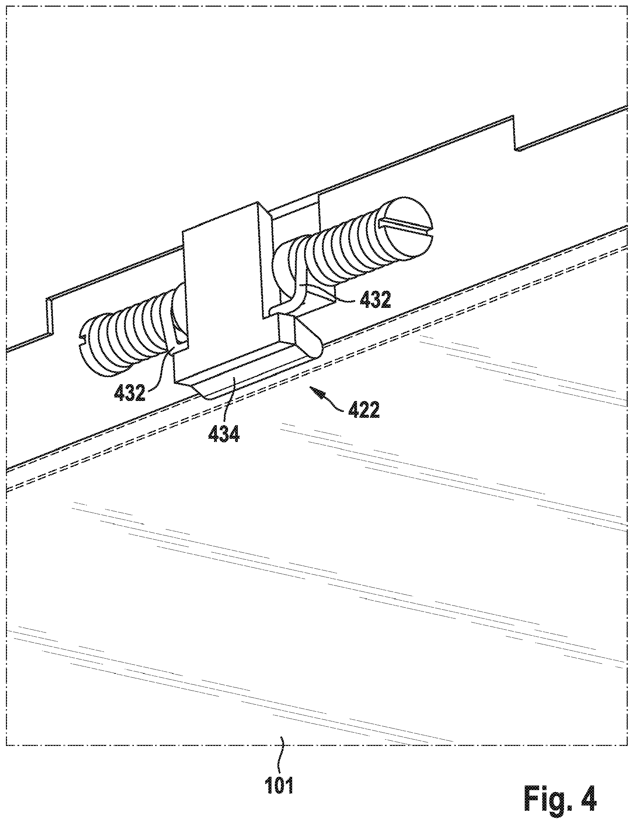

Figure 4 illustrates another example of the upper fixation element 422. The upper fixation element 422 is a spring clamp element having, typically, the first spring portion 432 and the second spring portion 432. A defined force can used to press the substrate against a contact surface of the support portion of the carrier. Thereby, a double leg spring element can be provided. The double leg spring is configured for providing sufficient force for allowing the substrate to hang at the substrate carrier. Accordingly, the double leg spring 432 is configured for providing a sufficient force such that the lever 434 pressing on substrate provides sufficient friction between the substrate and the lever itself and provides sufficient friction between the substrate and contact surface of the support portion of the carrier. The commonly used spring elements providing a force of about 3N are not sufficient to have the substrate hanging at a weight of e.g. 3 kg to 5 kg, which can be the weight for a GEN 7.5 substrate depending on the glass type and glass thickness.

According to some embodiments, which can be combined with other embodiments described herein, spring clamp elements at the upper side of the substrate area provide a force sufficient to provide friction forces at the lever arm allowing compensating at least the gravity forces of the substrate. Contrary thereto, for spring claim elements provided at the side of the substrate a force of 2 to 4 N is sufficient as the weight of the substrate is supported by the upper fixation element 122.

Thus, embodiments described herein are configured for a hanging glass or hanging substrate. Respective carriers for thin glass substrates with a thickness of 0.9 mm or below, typically with a thickness of 0.5 mm or below are provided. Further, methods of utilizing such carriers in processing systems and corresponding processing systems are provided.

According to some embodiments, which can be combined with other embodiments described herein, the fixation elements can be provided by clamp mounting elements. Thereby, the glass is pressed by a lever onto the contact surface of the supporting portion of the carrier. Accordingly, friction can be generated between the lever and the glass and/or between the supporting surface and the glass. According to some embodiments, additional or alternative implementations have the respective levers or surfaces being provided with a high fraction material such as a rubber material, or the like. Typically, this material should be suitable for vacuum enviromnents because many of the processing steps will be conducted under vacuum conditions.

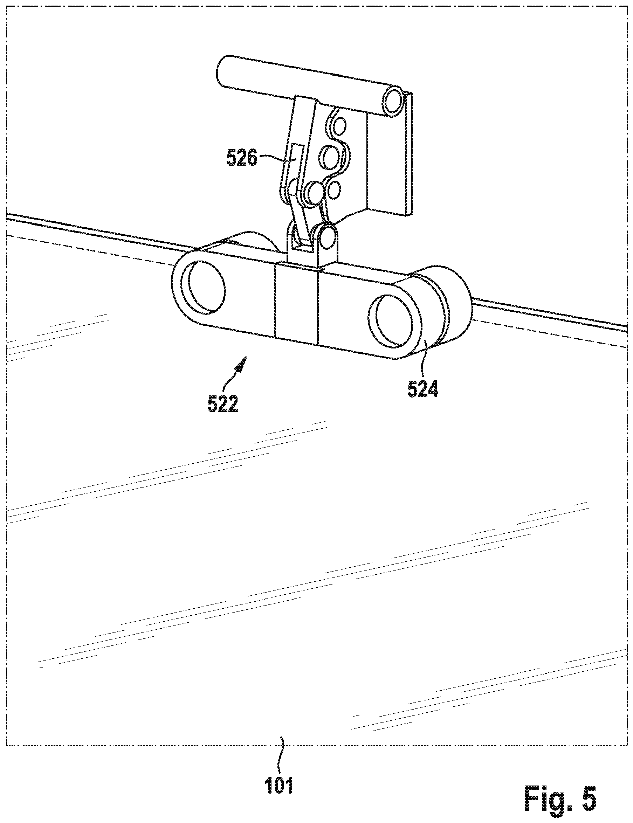

The spring elements shown in FIG. 4 provide a defined force to press the substrate against a contact surface at the carrier or the support portion respectively. The defined force can put up by using a spring as illustrated with respect to FIG. 4 or by using a system of self-securing levers, such as a knee lever. An example of a lever 522 , such as a knee lever, is shown in FIG. 5. The lever 522 can include a lever holder 526, e.g. with a self securing mechanism and bushes for contacting the substrate 101 and pressing the substrate against the contact surface of the support portion of the carrier plate. According to typical optional implementations, the bushes for pressing, which can be used with a lever, can include a pressure spring for defining a predetermined contact force. According to typical embodiments, the lever, and particularly the lever with a pressure spring can be adapted to be operated by a robot arm. According to embodiments described herein, loading of the substrate on the carrier can be conducted by a robot.

As described above, according to yet further embodiments, which can be combined with other embodiments described herein, to avoid bending or horizontal movement of the substrate, the substrate can be fixed and/or guided at the right/left and/or bottom side with suitable clamp elements or sliding elements.

As illustrate in the above embodiments, the carrier provides a support portion having an aperture, which can be used for also masking the edge of the substrate. Thereby, the contact surface at which the substrate is in contact with the carrier is provided essentially along the periphery of the substrate. The edge of the carrier forming the aperture can be used as an edge exclusion mask for processing steps such as deposition steps. However, according to yet further embodiments, the carrier can be provided by a plate or another contact surface. Thereby, an upper fixation element is similarly provided as described herein. However, the contact surface may vary from the frame shape having an aperture. Particularly for such support portion configurations, a separate edge exclusion mask can be provided.

Typically, the edge of a substrate may be defined as an area of the substrate which should be kept substantially free of deposition material or where the layer thickness of deposited material is reduced to a value of at least 25 % as compared to the un-masked substrate portion.

Typically, a substrate may be made from any material suitable for material deposition. For instance, the substrate may be made from a material selected from the group consisting of glass (for instance soda-lime glass, borosilicate glass etc.), metal, polymer, ceramic, compound materials, carbon fiber materials or any other material or combination of materials which can be coated by a deposition process. The bulging, which might also affect the processing of the substrate, can be reduced by the carriers according to embodiments described herein. Particularly for glass substrates or ceramic substrates, where breakage is a further concern, the carriers can also significantly reduce substrate breakage with reduces the productivity of a production processes due to the increased loss.

According to different embodiments, a carrier can be utilized for PVD deposition processes, CVD deposition process, substrate structuring edging, heating (e.g. annealing) or any kind of substrate processing. Embodiments of carriers as described herein and methods of utilizing such carriers are particularly useful for non-stationary, i.e. continuous substrate processing of the vertically oriented large area glass substrates. Non-Stationary processing typically requires that the carrier also provides masking elements for the process.

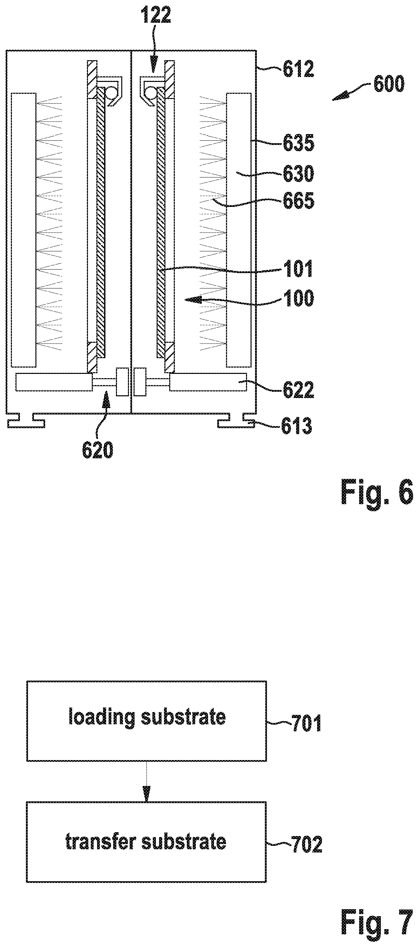

Fig. 6 shows a schematic view of a deposition chamber 600 according to embodiments. The deposition chamber 600 is adapted for a deposition process, such as a PVD or CVD process. A substrate 101 is shown being located within or at a carrier on a substrate transport device 620. A deposition material source 630 is provided in chamber 612 facing the side of the substrate to be coated. The deposition material source 630 provides deposition material 635 to be deposited on the substrate.

In Fig. 6, the source 630 may be a target with deposition material thereon or any other arrangement allowing material to be released for deposition on substrate 101. Typically, the material source 630 may be a rotatable target. According to some embodiments, the material source 630 may be movable in order to position and/or replace the source. According to other embodiments, the material source may be a planar target.

According to some embodiments, the deposition material 635 may be chosen according to the deposition process and the later application of the coated substrate. For instance, the deposition material of the source may be a material selected from the group consisting of: a metal, such as aluminum, molybdenum, titanium, copper, or the like, silicon, indium tin oxide, and other transparent conductive oxides. Typically, oxide-, nitride- or carbide-layers, which can include such materials, can be deposited by providing the material from the source or by reactive deposition, i.e. the material from the source reacts with elements like oxygen, nitride, or carbon from a processing gas. According to some embodiments, thin film transistor materials like siliconoxides, siliconoxynitrides, siliconnitrides, aluminumoxide, aluminumoxynitrides may be used as deposition material.

Typically, the substrate 101 is provided within or at a carrier, which can also serve as an edge exclusion mask, particularly for non-stationary deposition processes. Dashed lines 665 show exemplarily the path of the deposition material 635 during operation of the chamber 600. According to other embodiments, which can be combined with other embodiments described herein, the masking can be provided a separate edge exclusion mask which is provided in the chamber 612. Thereby, a carrier according to embodiments described herein can be beneficial for stationary processes and also for non-stationary processes.

According to some embodiments, a method is provided for depositing a deposition material layer on a substrate. Fig. 7 shows a flow diagram of the described method. Typically, step 701 denotes loading a substrate in a carrier. According to some embodiments, the substrate may be a substrate as described above and the deposition apparatus may be a deposition chamber as exemplarily shown in Fig. 6. Thereby, the substrate is typically be provided to be hanging in the carrier and/or at least one fixation element is provided which is configured to hold the substrate at the substrate's upper side and configured to carry at least 60% of the substrate's weight during processing of the substrate.

In step 702, the substrate is transferred into and/or through a processing chamber in an essentially vertical orientation. The carrier or a mask can cover an edge of the substrate. According to embodiments described herein, and which can be combined with other embodiments described herein, essentially vertical can be understood as a vertical oriented glass substrate, with a deviation of +- 10° or less, +- 5° or less, or even 3° or less. Depending on the entire setup of the application for which the processing is conducted and/or for which the carrier is utilized an exactly vertical orientation can have the advantage of less undesired particles on the substrate surface, whereas a slight inclination of the substrate can have the advantage that the substrate support is easier because of the a fixed orientation provided by the inclination.

According to some embodiments, the method for depositing material, deposition the apparatus and the mask for covering an edge of the substrate are used for large area substrates having a size of at least 0.174 m², particularly at least 1.4 m², more particularly at least 4 m².

According to embodiments, which can be combined with other embodiments described herein, the glass strains the bottom edge of the substrate with its own weight. Embodiments can provide a decrease in glass breakage, particularly in light of the fact that the substrates are getting bigger in length and height, however, the thickness of the substrates decreases. The bulging, which might also affect the processing of the substrate, can be reduced by the carriers according to embodiments described herein.

## Claims

1. A carrier (100) for supporting a large area glass substrate (101), particularly having an area of at least 0.174 m², in a substrate processing chamber, comprising:
at least one fixation element (122; 422, 522) configured to hold the glass substrate at the substrate's upper side and configured to carry at least 60% of the substrate's weight during processing of the substrate, wherein the at least one fixation element includes a lever and wherein the at least one fixation element is at least one element selected from the group consisting of: a spring clamp element (422), and a knee-lever clamp element (522);
at least one support portion (110) having an aperture and being adapted to hold the substrate at an essentially vertical orientation during processing of the substrate, wherein the support portion is configured to contact the substrate at only one side of the substrate and at a contact surface at which the substrate is in contact with the carrier essentially along the periphery of the substrate, and wherein the glass is pressed by the lever onto the contact surface; and
one or more side fixation elements (124) configured for receiving forces essentially perpendicular of gravity forces of the substrate in the vertical orientation.

2. The carrier according to claim 1, wherein the at least one fixation element (122; 422, 522) is configured for providing the substrate essentially hanging in the substrate area.

3. The carrier according to any of claims 1 to 2, wherein the at least one fixation element includes at least one double spring clamp element.

4. The carrier according to any of claims 1 to 3, wherein the at least one fixation element is configured for fixing the substrate having a thickness of 0.1 mm to 1.8 mm.

5. The carrier according to any of claims 1 to 4, wherein carrier is configured for positioning the substrate at a substrate area, and wherein the support portion having a surface, which is adapted to be in contact with at least a periphery of the substrate.

6. The carrier according to any of claims 1 to 5, wherein the at least one fixation element is configured so as to reduce or eliminate particle generation onto the substrate surface.

7. An apparatus (600) for depositing a layer on a large area glass substrate, comprising:
a vacuum chamber (612) adapted for layer deposition therein,
a transport system (620) with a carrier according to any of claims 1 to 6, particularly wherein the essentially vertical orientation is provided with respect to the processing chamber; and
a deposition source (630) for depositing material forming the layer.

8. A method of processing a large area glass substrate with a carrier according to any of claims 1 to 7, comprising:
loading the large area glass substrate, particularly having a size of 0.174 m² and above, on a carrier;
transferring the carrier together with the substrate into a processing chamber, wherein the substrate is in an essentially vertical orientation, wherein the substrate is hanging at the carrier; and
processing the substrate.

9. The method according to claim 8, wherein processing is a non-stationary processing and/or wherein the substrate is transferred into the processing chamber, through the processing chamber and out of the processing chamber without stopping of a movement of the transfer.

10. The method according to any of claims 8 to 9, wherein the hanging is provided by the upper fixation element fixing the position of the upper edge of the substrate.

## Patentansprüche

1. Träger (100) zum Tragen eines großflächigen Glassubstrats (101) insbesondere mit einer Fläche von mindestens 0,174 m² in einer Substratverarbeitungskammer, umfassend:
mindestens ein Befestigungselement (122; 422, 522), das konfiguriert ist, das Glassubstrat an der Oberseite des Substrats zu halten, und das konfiguriert ist, mindestens 60 % des Gewichts des Substrats während der Verarbeitung des Substrats zu tragen, wobei das mindestens eine Befestigungselement einen Hebel umfasst, und wobei das mindestens eine Befestigungselement mindestens ein Element ist, das ausgewählt ist aus der Gruppe bestehend aus: einem Federklemmenelement (422) und einem Kniehebelklemmenelement (522);
mindestens einen Tragabschnitt (110) mit einer Öffnung, der angepasst ist, das Substrat in im Wesentlichen vertikaler Ausrichtung während der Verarbeitung des Substrats zu halten, wobei der Tragabschnitt konfiguriert ist, das Substrat an nur einer Seite des Substrats und an einer Kontaktfläche, an der das Substrat mit dem Träger im Wesentlichen entlang der Peripherie des Substrats in Kontakt ist, zu kontaktieren, und wobei das Glas durch den Hebel auf die Kontaktfläche gedrückt wird; und
ein oder mehrere Seitenbefestigungselemente (124), die zum Aufnehmen von Kräften, die zu Gravitationskräften des Substrats in der vertikalen Ausrichtung im Wesentlichen senkrecht sind, konfiguriert sind.

2. Träger nach Anspruch 1, wobei das mindestens eine Befestigungselement (122; 422, 522) zum Bereitstellen des Substrats im Wesentlichen hängend in der Substratfläche konfiguriert ist.

3. Träger nach einem der Ansprüche 1 bis 2, wobei das mindestens eine Befestigungselement mindestens ein Doppelfederklemmenelement umfasst.

4. Träger nach einem der Ansprüche 1 bis 3, wobei das mindestens eine Befestigungselement zur Befestigung des Substrats mit einer Dicke von 0,1 mm bis 1,8 mm konfiguriert ist.

5. Träger nach einem der Ansprüche 1 bis 4, wobei der Träger zur Positionierung des Substrats an einer Substratfläche konfiguriert ist, und wobei der Tragabschnitt eine Fläche aufweist, die angepasst ist, in Kontakt mit mindestens einer Peripherie des Substrats zu sein.

6. Träger nach einem der Ansprüche 1 bis 5, wobei das mindestens eine Befestigungselement konfiguriert ist, eine Partikelerzeugung auf die Substratfläche zu reduzieren oder zu eliminieren.

7. Vorrichtung (600) zum Abscheiden einer Schicht auf einem großflächigen Glassubstrat, umfassend:
eine Vakuumkammer (612), die zur Schichtabscheidung darin angepasst ist,
ein Transportsystem (620) mit einem Träger nach einem der Ansprüche 1 bis 6, wobei insbesondere die im Wesentlichen vertikale Ausrichtung in Bezug auf die Verarbeitungskammer bereitgestellt wird; und
eine Abscheidungsquelle (630) zum Abscheiden von Material, das die Schicht bildet.

8. Verfahren zur Verarbeitung eines großflächigen Glassubstrats mit einem Träger nach einem der Ansprüche 1 bis 7, umfassend:
Laden des großflächigen Glassubstrats, das insbesondere eine Größe von 0,174 m² und darüber aufweist, auf einen Träger;
Übertragen des Trägers zusammen mit dem Substrat in eine Verarbeitungskammer, wobei das Substrat in einer im Wesentlichen vertikalen Ausrichtung ist, wobei das Substrat an dem Träger hängt; und
Verarbeiten des Substrats.

9. Verfahren nach Anspruch 8, wobei das Verarbeiten ein nicht stationäres Verarbeiten ist, und/oder wobei das Substrat in die Verarbeitungskammer durch die Verarbeitungskammer und aus der Verarbeitungskammer heraus ohne Stoppen einer Bewegung der Übertragung übertragen wird.

10. Verfahren nach einem der Ansprüche 8 bis 9, wobei das Hängen durch das obere Befestigungselement bereitgestellt wird, das die Position der Oberkante des Substrats befestigt.

## Revendications

1. Support (100) permettant de soutenir un substrat de verre de grande surface (101), en particulier ayant une surface d'au moins 0,174 m², dans une chambre de traitement de substrat, comprenant :
au moins un élément de fixation (122 ; 422, 522) conçu pour maintenir le substrat de verre sur le côté supérieur du substrat et conçu pour supporter au moins 60 % du poids du substrat pendant le traitement du substrat, dans lequel l'au moins un élément de fixation inclut un levier et dans lequel l'au moins un élément de fixation est au moins un élément choisi parmi le groupe constitué : d'un élément de serrage à ressort (422), et d'un élément de serrage à genouillère (522) ;
au moins une partie de support (110) présentant une ouverture et étant adapté pour maintenir le substrat dans une orientation essentiellement verticale pendant le traitement du substrat, dans lequel la partie de support est conçue pour entrer en contact avec le substrat seulement au niveau d'un côté du substrat et au niveau d'une surface de contact sur laquelle le substrat est en contact avec le support essentiellement le long de la périphérie du substrat, et dans lequel le verre est pressé par le levier sur la surface de contact ; et
un ou plusieurs éléments de fixation latérale (124) conçus pour recevoir des forces essentiellement perpendiculaires de forces de gravité du substrat dans l'orientation verticale.

2. Support selon la revendication 1, dans lequel l'au moins un élément de fixation (122 ; 422, 522) est conçu pour maintenir le substrat en suspension essentiellement dans la zone de substrat.

3. Support selon la revendication 1 ou la revendication 2, dans lequel l'au moins un élément de fixation inclut au moins un élément de serrage à ressort double.

4. Support selon l'une quelconque des revendications 1 à 3, dans lequel l'au moins un élément de fixation est conçu pour la fixation du substrat ayant une épaisseur comprise entre 0,1 mm et 1,8 mm.

5. Support selon l'une quelconque des revendications 1 à 4, dans lequel le support est conçu pour le positionnement du substrat au niveau d'une zone de substrat, dans lequel la partie de support possédant une surface, qui est adaptée pour être en contact avec au moins une périphérie du substrat.

6. Support selon l'une quelconque des revendications 1 à 5, dans lequel l'au moins un élément de fixation est conçu de façon à réduire ou éliminer la production de particules sur la surface de substrat.

7. Appareil (600) permettant de déposer une couche sur un substrat de verre de grande surface, comprenant :
une chambre sous vide (612) adaptée pour un dépôt de couche dans celle-ci,
un système de transport (620) muni d'un support selon l'une quelconque des revendications 1 à 6, en particulier dans lequel l'orientation essentiellement verticale est maintenue par rapport à la chambre de traitement ; et
une source de dépôt (630) permettant de déposer un matériau formant la couche.

8. Procédé de traitement d'un substrat de verre de grande surface muni d'un support selon l'une quelconque des revendications 1 à 7, comprenant :
le chargement du substrat de verre de grande surface, en particulier ayant une taille de 0,174 m² ou plus, sur un support ;
le transfert du support ensemble avec le substrat dans une chambre de traitement, dans lequel le substrat est dans une orientation essentiellement verticale, dans lequel le substrat est en suspens au niveau du support ; et
le traitement du substrat.

9. Procédé selon la revendication 8, dans lequel le traitement est un traitement non stationnaire et/ou dans lequel le substrat est transféré dans la chambre de traitement, à travers la chambre de traitement et en dehors de la chambre de traitement sans l'arrêt d'un mouvement du transfert.

10. Procédé selon l'une quelconque des revendications 8 à 9, dans lequel la suspension est fournie au moyen de l'élément de fixation supérieur permettant de fixer la position du bord supérieur du substrat.
